(19) Europäisches Patentamt / European Patent Office / Office européen des brevets

(11) EP 4 768 941 A1

(12) **EUROPEAN PATENT APPLICATION**
published in accordance with Art. 153(4) EPC

(43) Date of publication:
01.07.2026 Bulletin 2026/27

(21) Application number: 24937278.0

(22) Date of filing: 19.11.2024

(51) International Patent Classification (IPC):
$G01R\ 31/382^{(2019.01)}$   $G01R\ 31/392^{(2019.01)}$
$G01R\ 31/367^{(2019.01)}$   $G01R\ 19/165^{(2006.01)}$
$G01R\ 31/56^{(2020.01)}$   $H02J\ 7/00^{(2026.01)}$

(52) Cooperative Patent Classification (CPC):
G01R 19/165; G01R 31/367; G01R 31/382;
G01R 31/392; G01R 31/56; H02J 7/00

(86) International application number:
PCT/KR2024/018214

(87) International publication number:
WO 2025/225805 (30.10.2025 Gazette 2025/44)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 24.04.2024 KR 20240054760

(71) Applicant: LG Energy Solution, Ltd.
Seoul 07335 (KR)

(72) Inventor: SUNG, Yong Chul
Daejeon 34122 (KR)

(74) Representative: Plasseraud IP
104 Rue de Richelieu
CS92104
75080 Paris Cedex 02 (FR)

(54) **BATTERY DIAGNOSIS DEVICE AND METHOD**

(57) A battery diagnosis apparatus according to an embodiment disclosed herein includes an interface unit configured to obtain after-charging state of charge (SOC) in every charging cycle, for each of a plurality of battery cells and one or more processors configured to calculate a charging amount-to-average of each of the plurality of battery cells, based on the after-charging SOC, calculate a change degree of the charging amount-to-average of each of the plurality of battery cells with respect to a charging cycle, calculate an indicator by applying a cycle-specific weight value to a change degree of a charging amount-to-average of a diagnosis target battery cell among the plurality of battery cells, and diagnose abnormality of the diagnosis target battery cell based on cycle-specific indicators of the diagnosis target battery cell.

<u>100</u>

INTERFACE UNIT 110 — ONE OR MORE PROCESSORS 120

FIG.1

**Description**

## TECHNICAL FIELD

CROSS-REFERENCE TO RELATED APPLICATION

This application claims priority to and the benefit of Korean Patent Application No. 10-2024-0054760 filed in the Korean Intellectual Property Office on April 24, 2024, the entire content of which is incorporated herein by reference.

TECHNICAL FIELD

Embodiments disclosed herein relate to a battery diagnosis apparatus and method.

## BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery is generally used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (electric vehicles (EV), hybrid electric vehicles (HEV), plug-in HEV (PHEV)) driven with electricity, large-volume energy storage systems (ESS), etc.

These batteries may be managed and controlled in terms of states and operations thereof by a battery management system (BMS). The battery management system may be included together with a battery in one device.

The battery management system may also manage and control the battery in a state of being spaced apart from a device including the battery. For example, the battery management system may be implemented as a separate server device. In this case, the battery management system may collect battery data and vehicle data from the vehicle, etc., and manage and control the battery using the collected data.

Meanwhile, when a battery has a defect, the possibility of damage to devices (e.g., an EV, an ESS) including the battery may increase. Accordingly, there is a need for a scheme to reduce the possibility of damage to devices including a battery by detecting an abnormal state of the battery.

## DISCLOSURE

TECHNICAL PROBLEM

Generally, an abnormal behavior diagnosis of a voltage due to a tab short-circuit, etc., of a battery cell may be one of major items of abnormal diagnosis of the battery cell. However, a conventional voltage abnormal behavior diagnosis method has a limitation in detecting a subtle voltage change.

Embodiments disclosed herein aim to provide a battery diagnosis apparatus and method capable of effectively diagnosing abnormality of a battery cell by defining a charging amount-to-average of each battery cell based on after-charging SOC of battery cells and analyzing the charging amount-to-average to detect a subtle voltage change.

Technical problems of the embodiments disclosed herein are not limited to the above-described technical problems, and other unmentioned technical problems would be clearly understood by one of ordinary skill in the art from the following description.

TECHNICAL SOLUTION

A battery diagnosis apparatus according to an embodiment disclosed herein includes an interface unit configured to obtain after-charging state of charge (SOC) in every charging cycle, for each of a plurality of battery cells and one or more processors configured to calculate a charging amount-to-average of each of the plurality of battery cells, based on the after-charging SOC, calculate a change degree of the charging amount-to-average of each of the plurality of battery cells with respect to a charging cycle, calculate an indicator by applying a cycle-specific weight value to a change degree of a charging amount-to-average of a diagnosis target battery cell among the plurality of battery cells, and diagnose abnormality of the diagnosis target battery cell based on cycle-specific indicators of the diagnosis target battery cell.

According to an embodiment, the interface unit may be further configured to obtain SOC after a designated time from end of each charging cycle, for each of the plurality of battery cells.

According to an embodiment, the processor may be further configured to calculate after-charging average SOC of each of the plurality of battery cells in every charging cycle, calculate a total cycle average based on the after-charging average SOC calculated in every charging cycle, and calculate the charging amount-to-average based on the after-charging SOC, the after-charging average SOC, and the total cycle average.

According to an embodiment, the processor may be further configured to calculate a difference between a charging amount-to-average in a first charging cycle among the plurality of charging cycles and a charging amount-to-average in a second charging cycle previous to the first charging cycle, as the change degree of the charging amount-to-average corresponding to the first charging cycle.

According to an embodiment, the processor may be further configured to calculate an average change degree indicating an average of charging amount-to-average change degrees of the other battery cells than the diagnosis target battery cell among the plurality of battery cells in the first charging cycle, identify a minimum change degree indicating a minimum value among the charging amount-to-average change degrees of the other battery cells in the first charging cycle, and calculate a weight value in the first charging cycle by multiplying a greater value between the average change degree and the minimum change degree by a charging amount-to-average change degree of the diagnosis target battery cell in the first charging cycle.

According to an embodiment, the processor may be further configured to calculate an indicator corresponding to the first charging cycle by dividing the charging amount-to-average change degree of the diagnosis target battery cell in the first charging cycle by a weight value in the first charging cycle.

According to an embodiment, the processor may be further configured to diagnose abnormality of the diagnosis target battery cell by comparing a maximum value among cycle-specific indicators of the diagnosis target battery cell with a threshold value.

According to an embodiment disclosed herein, a battery diagnosis method includes obtaining after-charging state of charge (SOC) in every charging cycle, for each of a plurality of battery cells, calculating a charging amount-to-average of each of the plurality of battery cells, based on the after-charging SOC, calculating a change degree of the charging amount-to-average of each of the plurality of battery cells with respect to a charging cycle, calculating an indicator by applying a cycle-specific weight value to a change degree of a charging amount-to-average of a diagnosis target battery cell among the plurality of battery cells, and diagnosing abnormality of the diagnosis target battery cell based on cycle-specific indicators of the diagnosis target battery cell.

According to an embodiment, the obtaining of the after-charging SOC may include obtaining SOC after a designated time from end of each charging cycle, for each of the plurality of battery cells.

According to an embodiment, the calculating of the charging amount-to-average of each of the plurality of battery cells may include calculating after-charging average SOC of each of the plurality of battery cells in every charging cycle, calculating a total cycle average based on the after-charging average SOC calculated in every charging cycle, and calculating the charging amount-to-average based on the after-charging SOC, the after-charging average SOC, and the total cycle average.

According to an embodiment, the calculating of the change degree of the charging amount-to-average may include calculating a difference between a charging amount-to-average in a first charging cycle among the plurality of charging cycles and a charging amount-to-average in a second charging cycle previous to the first charging cycle, as the change degree of the charging amount-to-average corresponding to the first charging cycle.

According to an embodiment, the calculating of the indicator may include calculating an average change degree indicating an average of charging amount-to-average change degrees of the other battery cells than the diagnosis target battery cell among the plurality of battery cells in the first charging cycle, identifying a minimum change degree indicating a minimum value among the charging amount-to-average change degrees of the other battery cells in the first charging cycle, calculating a weight value in the first charging cycle by multiplying a greater value between the average change degree and the minimum change degree by a charging amount-to-average change degree of the diagnosis target battery cell in the first charging cycle, and calculating an indicator corresponding to the first charging cycle by dividing the charging amount-to-average change degree of the diagnosis target battery cell in the first charging cycle by a weight value in the first charging cycle.

According to an embodiment, the diagnosing of abnormality of the diagnosis target battery cell may include diagnosing abnormality of the diagnosis target battery cell by comparing a maximum value among cycle-specific indicators of the diagnosis target battery cell with a threshold value.

## ADVANTAGEOUS EFFECTS

A battery diagnosis apparatus and method according to embodiments disclosed herein may effectively diagnose abnormality of a battery cell by defining a charging amount-to-average of a battery cell based on after-charging SOC.

In addition, various effects identified directly or indirectly through this document may be provided.

## DESCRIPTION OF DRAWINGS

FIG. 1 shows a configuration of a battery diagnosis apparatus according to an embodiment disclosed herein.

FIG. 2 is a diagram showing an example of obtaining after-charging SOC according to an embodiment disclosed herein.

FIGS. 3A to 3E show an example of a process of diagnosing a battery, according to an embodiment disclosed herein.

FIG. 4 is a diagram showing an example of a process of calculating an indicator from after-charging SOC data, according to an embodiment disclosed herein.

FIGS. 5 to 7 are flowcharts of a battery diagnosis method according to an embodiment disclosed herein.

FIG. 8 is a block diagram showing a hardware configuration of a computing system for performing an operating method of a battery diagnosis apparatus, according to an embodiment disclosed herein.

## MODE FOR INVENTION

Hereinafter, various embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

Herein, it is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

Each component (e.g., a module or a program) of the components described herein may include a single entity or multiple entities. According to various embodiments, one or more of the components may be omitted, or one or more other components may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

As used herein, the term "module" or "...unit" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments of the present document may be implemented as software (e.g., a program or application) including one or more instructions that are stored in a storage medium (e.g., a memory) that is readable by a machine. For example, a processor of the machine may invoke at least one of the one or more instructions stored in the storage medium, and execute it. This may enable the machine to operate to perform at least one function according to the at least one called instruction. The one or more instructions may include a code generated by a compiler or a code executable by an interpreter. A machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semipermanently stored in the storage medium and where the data is temporarily stored in the storage medium.

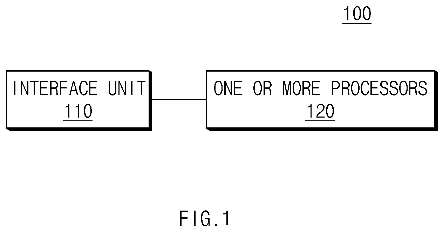

FIG. 1 shows a configuration of a battery diagnosis apparatus according to an embodiment disclosed herein.

Referring to FIG. 1, the battery diagnosis apparatus 100 may include an interface unit 110 and one or more processor 120.

The battery diagnosis apparatus 100 may analyze SOC of a plurality of battery cells to diagnose whether a diagnosis target battery is abnormal. More specifically, the battery diagnosis apparatus 100 may define a charging amount-to-average based on SOC of a battery cell and detect a subtle voltage change of the battery cell by analyzing the charging amount-to-average, thereby effectively diagnosing abnormality such as a tab short-circuit, etc., causing the subtle voltage change.

The following operation of the battery diagnosis apparatus 100 may also be performed in various devices such as not only a battery management system (BMS) in a vehicle and a battery BMS included in a battery pack, but also a server, a cloud, a charger, a charger/discharger, etc.

The interface unit 110 may establish connection between the battery diagnosis apparatus 100 and an electronic device (e.g., a server, a BMS of a battery pack, a vehicle BMS, etc.) and transmit and receive data through the established connection. The connection between the interface unit 110 and the electronic device may be communication connection over a wired and/or wireless network. In an embodiment, the wired network may be based on a local area network (LAN) communication or a powerline communication. In an embodiment, the wireless network may be based on a shortrange communication network (e.g., Bluetooth, Wireless Fidelity (WiFi), or Infrared Data Association (IrDA)) or a remote-range communication network (e.g., a cellular network, a 4th-Generation (4G) network, a 5th-Generation (5G) network).

According to another embodiment, the connection between the battery diagnosis apparatus 100 and the electronic device may be connection using a device-to-device communication scheme (e.g., a bus, a general-purpose input and output (GPIO), a serial peripheral interface (SPI), or a mobile industry processor interface (MIPI)).

The interface unit 110 may obtain information of the plurality of battery cells. The plurality of battery cells may be cells included in the same battery pack, module, or bank.

In an embodiment, when the battery diagnosis apparatus 100 is implemented with a component (e.g., an external server for the electronic device, etc.) separate from the electronic device, the interface unit 110 may obtain information of battery cells through a communication channel established between the battery diagnosis apparatus 100 and the electronic device.

In another embodiment, when the battery diagnosis apparatus 100 is implemented with a BMS in the electronic device, the interface unit 110 may obtain the information of the battery cells from at least one sensor capable of measuring information (e.g., voltage, current, temperature, etc.) related to states of the battery cells.

The interface unit 110 may obtain after-charging SOC of each battery cell in every charging cycle. For example, when 10 charging cycles progress for each battery cell, the interface unit 110 may obtain 10 pieces of data regarding after-charging SOC for each battery cell.

According to an embodiment, the interface unit 110 may obtain SOC after a designated time from the end of each charging cycle, for each of the plurality of battery cells.

Immediately after the end of charging, there is a possibility of a voltage change of a battery cell, such that SOC of a battery cell may be obtained in a voltage-stabilized state after the end of a charging cycle to obtain an accurate SOC value. To this end, the interface unit 110 may obtain SOC of each battery cell at a point in time after the designated time from the end of the charging cycle. For example, the designated time may be set to a time sufficient to stabilize a voltage, for example, two hours.

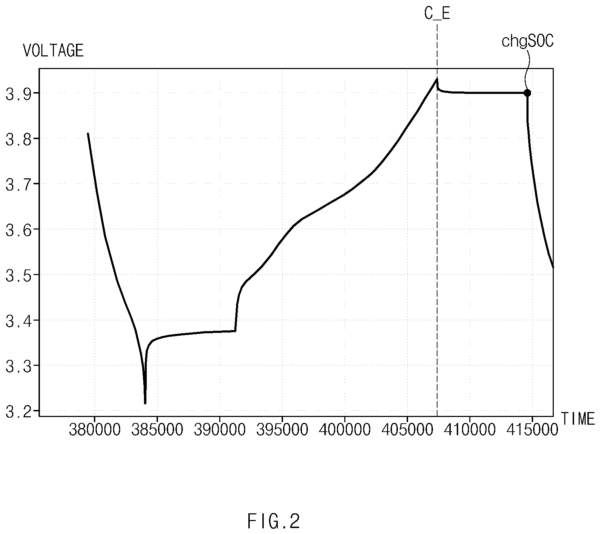

For example, the interface unit 110 may obtain SOC at a time point T after the designated time from an end point C_E of a charging cycle of the battery cell, as shown in FIG. 2. In FIG. 2, an x axis indicates a time and a y axis indicates a voltage, and chgSOC conceptually indicates that after-charging SOC is obtained at an indicated time point. That is, the battery diagnosis apparatus 100 may identify a time point for obtaining after-charging SOC of a battery cell from voltage data over time.

The interface unit 110 may obtain additional information related to a battery, such as voltage, temperature, SOH, etc., of a battery cell as well as the after-charging SOC.

The processor 120 may be implemented as one or more processors. Each processor may include a central processing unit, an application processor, a graphic processing unit, a neural processing unit (NPU), an image signal processor, a sensor hub processor, or a communication processor.

The processor 120 may diagnose abnormality of a diagnosis target battery cell and/or each battery cell by using after-charging SOC of the battery cells, obtained by the interface unit 110. For example, the processor 120 may detect a subtle voltage change of each battery cell by analyzing the after-charging SOC of each battery cell, thereby diagnosing abnormality of the battery cell.

Functions and operations of the battery diagnosis apparatus 100 described below may be performed by one processor, and at least some of the functions may be separately performed by a plurality of processors. Hereinbelow, for convenience, a description will be made of a case where the operations of the battery diagnosis apparatus 100 are performed by one processor.

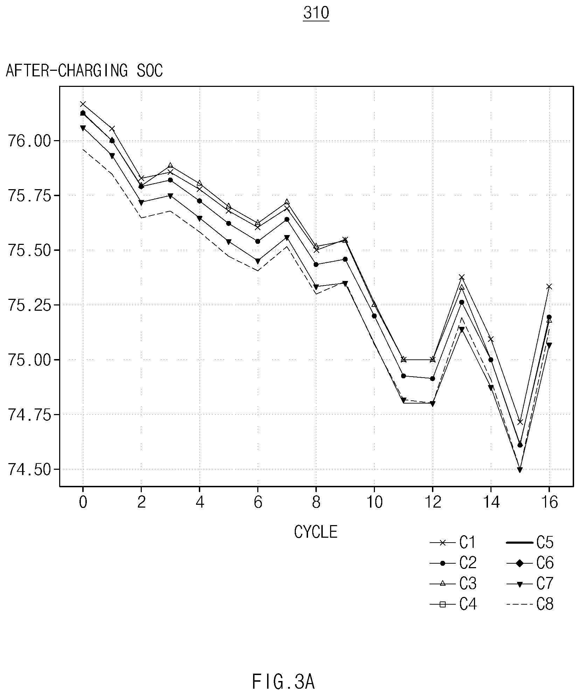

FIGS. 3A to 3E show an example of a process of diagnosing a battery, according to an embodiment disclosed herein.

Hereinbelow, with reference to FIGS. 3A to 3E, the operations of the battery diagnosis apparatus 100 will be described in detail.

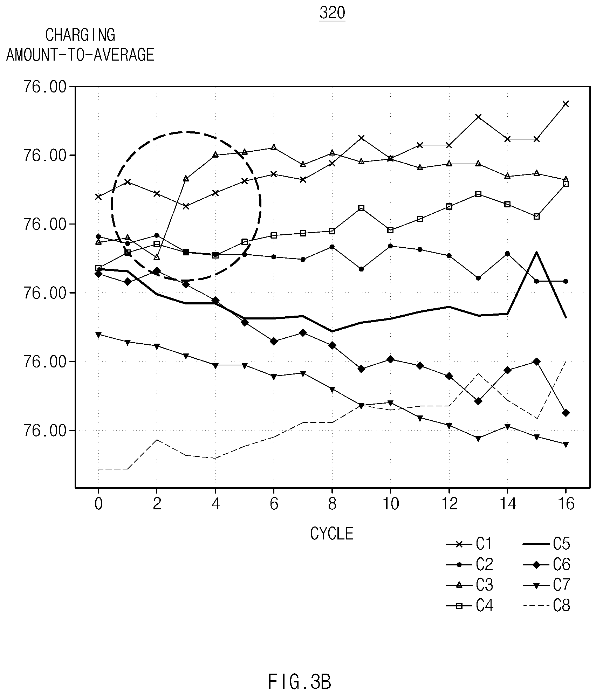

The interface unit 110 may obtain after-charging SOC in each charging cycle for each battery cell as shown in a graph 310 of FIG. 3A. The graph 310 shows after-charging SOC data obtained after 17 charging cycles 0 to 16 of each of 8 battery cells C1 to C8 in which an x axis indicates a cycle number and a y axis indicates after-charging SOC. Graphs shown in FIGS. 3B to 3E show values calculated based on after-charging SOC indicated in the graph 310 of FIG. 3A.

The processor 120 may calculate a charging amount-to-average of each of the plurality of battery cells based on the after-charging SOC. Herein, the charging amount-to-average may be a parameter defined for comparing relative charging amounts of the battery cells in each charging cycle. The processor 120 may calculate a charging amount-to-average indicating a relative charging amount for each battery cell to detect a relative subtle behavior of a diagnosis target battery cell in comparison to the other battery cells.

According to an embodiment, the processor 120 may calculate after-charging average SOC of each of the plurality of battery cells in every charging cycle. For each charging cycle, the processor 120 may average after-charging SOC of the battery cells, obtained in the corresponding charging cycle, to calculate the after-charging average SOC. For example, when 10 charging cycles progress for each battery cell, the processor 120 may calculate after-charging average SOC in every charging cycle to calculate 10 pieces of after-charging average SOC data.

The processor 120 may calculate a total cycle average based on the after-charging average SOC calculated in every charging cycle. The processor 120 may average the after-charging average SOC to calculate the total cycle average.

The processor 120 may calculate a charging amount-to-average based on the after-charging SOC, the after-charging average SOC, and the total cycle average. The processor 120 may convert the after-charging SOC of each battery cell into the charging amount-to-average by using the after-charging average SOC and the total cycle average.

In an embodiment, the processor 120 may calculate the charging amount-to-average of each battery cell based on Equation 1 below.

[Equation 1]

$$chgSOCnorm = chgSOC * (norm/avg)$$

Herein, chgSOCnorm may indicate the charging amount-to-average of each battery cell in each charging cycle, chgSOC may indicate the after-charging SOC of each battery cell in each charging cycle, avg may indicate the after-charging average SOC, and norm may indicate the total cycle average.

As such, the processor 120 may derive a relative charging amount of each battery cell. The charging amount-to-average of each battery cell, calculated by the processor 120, may be shown in a graph 320 of FIG. 3B. In FIG. 3B, a y axis indicates the charging amount-to-average.

It may be seen that a part of the graph 320, indicated by a circle, may more clearly show relative comparison in the charging amount-to-average of each battery cell than the graph 310 showing the after-charging SOC of each battery cell.

The processor 120 may calculate a change degree of the charging amount-to-average of each of the plurality of battery cells with respect to a charging cycle. The processor 120 may calculate the change degree of the charging amount-to-average with respect to the charging cycle from the charging amount-to-average of each battery cell.

According to an embodiment, the processor 120 may calculate a difference between a charging amount-to-average in a first charging cycle among the plurality of charging cycles and a charging amount-to-average in a second charging cycle previous to the first charging cycle, as a change degree of a charging amount-to-average corresponding to the first charging cycle. The difference between the charging amount-to-average in the first charging cycle and the charging amount-to-average in the second charging cycle may mean an absolute value.

An interval between the first charging cycle and the second charging cycle may be preset. For example, the first charging cycle and the second charging cycle may be adjacent cycles. In another example, an interval between the first charging cycle and the second charging cycle may be an n cycle interval (n is an integer of at least 2). For example, when the first charging cycle is an $m^{th}$ (m is an integer of at least 2) cycle, the second charging cycle may be an $(m-2)^{th}$ cycle.

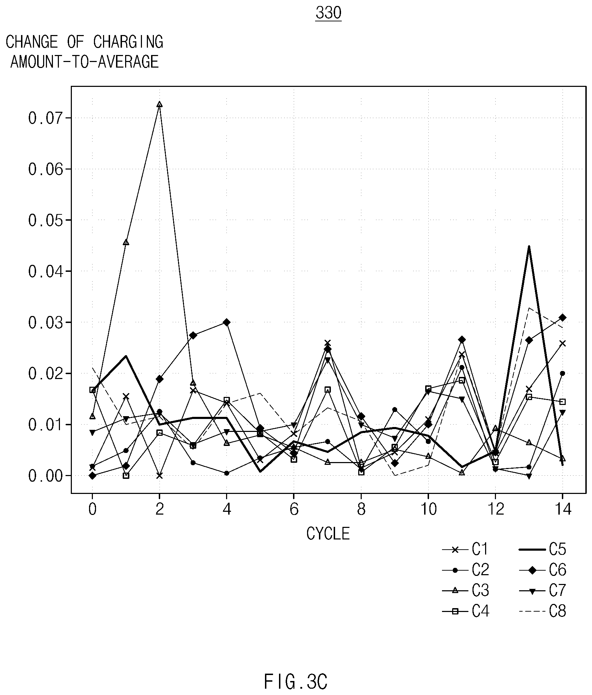

As such, the processor 120 may apply a difference between the charging amount-to-averages in the first charging cycle and the second charging cycle to every battery cell and cycle. The change degree of the charging amount-to-average, calculated by the processor 120, may be shown in a graph 330 of FIG. 3C. The change degree of the charging amount-to-average in the graph 330 in FIG. 3C shows a result for n = 2 in the charging amount-to-average of the graph 320. For example, in FIG. 3C, an y axis may indicate a change degree of a charging amount-to-average and it may be seen that a cell C3 has a greater change degree of a charging amount than the other cells.

The processor 120 may calculate an indicator by applying a cycle-specific weight value to a change degree of a charging amount-to-average of a diagnosis target battery cell among the plurality of battery cells. The indicator may be a value that is a reference for the processor 120 to diagnose abnormality of the diagnosis target battery cell. The processor 120 may calculate the indicator from the change degree of the charging amount-to-average to detect a subtle voltage change based on a change of the charging amount of the battery cell.

According to an embodiment, the processor 120 may calculate a weight value to be applied to the diagnosis target battery cell from charging amount-to-average change degree data of the battery cells.

To this end, first, the processor 120 may calculate an average change degree indicating an average of charging amount-to-average change degrees of the other battery cells than the diagnosis target battery cell among the plurality of battery cells in the first charging cycle, and identify a minimum change degree indicating a minimum value among the charging amount-to-average change degrees of the other battery cells than the diagnosis target battery cell in the first charging cycle.

The processor 120 may calculate a weight value to be applied to the diagnosis target battery cell based on the average change degree and the minimum change degree. In an embodiment, the processor 120 may multiply the greater value between the average change degree and the minimum change degree by the charging amount-to-average change degree of the diagnosis target battery cell in the first charging cycle to calculate the weight value in the first charging cycle.

The processor 120 may calculate an indicator of each battery cell by using the calculated weight value. According to an embodiment, the processor 120 may divide the charging amount-to-average change degree of the diagnosis target battery cell in the first charging cycle by the weight value in the first charging cycle to calculate the indicator corresponding to the first charging cycle. The indicator may reflect a rate of a variance of the diagnosis target battery cell with respect to the other cells.

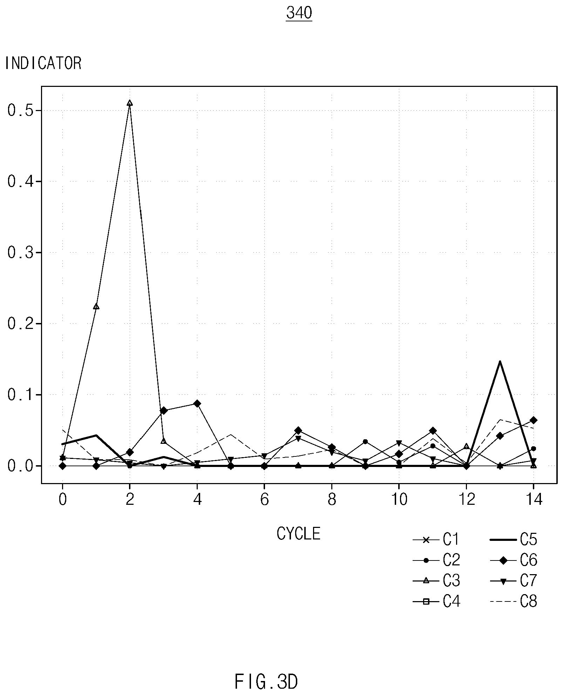

Indicators calculated by the processor 120 may be shown in a graph 340 of FIG. 3D. In the graph 340, an y axis may indicate an indicator, and it may be seen that tendencies of battery cells are clearly different from each other and a relative change degree of the cell C3 is clearly different from those of the other cells.

The processor 120 may diagnose abnormality of the diagnosis target battery cell based on an indicator of the diagnosis target battery cell corresponding to each cycle. The indicators calculated as described above may reflect relative voltage change characteristics between the battery cells, such that the processor 120 may detect a subtle voltage change of the diagnosis target battery cell by using the indicators to diagnose abnormality.

According to an embodiment, the processor 120 may compare a maximum value among the indicators of the diagnosis target battery cell corresponding to each cycle with a threshold value to diagnose abnormality of the diagnosis target battery cell. For example, the processor 120 may diagnose that the diagnosis target battery cell is abnormal when the maximum value among the indicators of the diagnosis target battery cell exceeds the threshold value. When the maximum value among the indicators of the diagnosis target battery cell is great, it may mean that the diagnosis target battery cell has a greater voltage change than the other cells, such that abnormality of the battery cell may be diagnosed by comparison between the maximum value among the indicators and the threshold value.

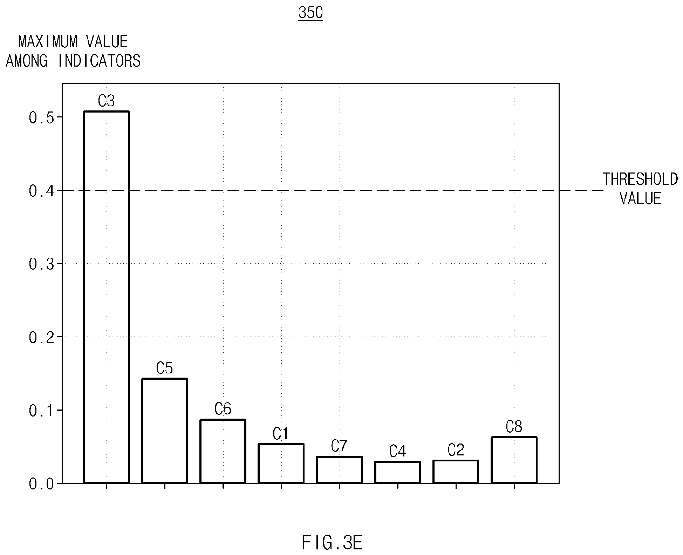

The processor 120 may identify the maximum value among the indicators of each battery cell for comparison with the threshold value, as in a graph 350 shown in FIG. 3E. Referring to the graph 350, as the maximum value among the indicators for the cell C3 exceeds the threshold value, the processor 120 may diagnose that the cell C3 is abnormal.

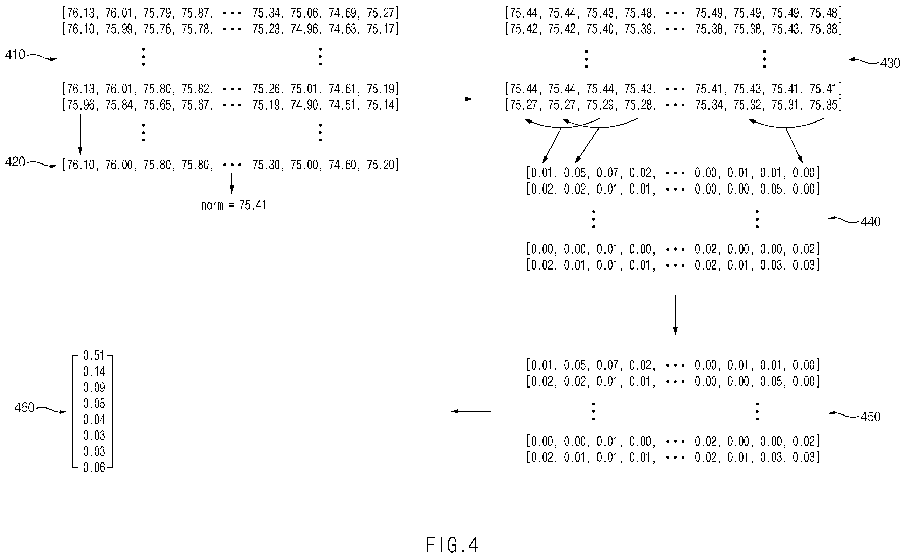

FIG. 4 is a diagram showing an example of a process of calculating an indicator from after-charging SOC data, according to an embodiment disclosed herein.

Referring to FIG. 4, an example of a process, performed by the processor 120, of analyzing data to diagnose each battery cell using data obtained from the interface unit 110 may be seen.

First, the interface unit 110 may obtain/store after-charging SOC of each battery cell, obtained for each cycle, in a matrix form, as indicated by 410 of FIG. 4. In a matrix 410 of FIG. 4, each row may indicate a battery cell and each column may indicate a cycle, and each component of the matrix may indicate an after-charging SOC value.

The processor 120 may average after-charging SOC of each battery cell every cycle to calculate after-charging average SOC in which the after-charging average SOC calculated from the matrix 410 is shown as a matrix 420. That is, the processor 120 may calculate the matrix 420 through a process of averaging components of each column of the matrix 410.

The processor 120 may average after-charging average SOC of each charging cycle to calculate a total cycle average in which the total cycle average calculated from the matrix 420 is expressed as a norm. That is, the processor 120 may average all components of the matrix 420 to calculate the total cycle average.

The processor 120 may calculate the charging amount-to-average of each battery cell based on the after-charging SOC, the after-charging average SOC, and the total cycle average, and an example of the charging amount-to-average is shown as a matrix 430. Sizes of the matrix 410 and the matrix 430 may be the same as each other.

The processor 120 may calculate a change degree of the charging amount-to-average of each battery cell with respect to a charging cycle, and an example of the change degree is shown as a matrix 440. The matrix 440 may show a result when a cycle interval is a 2-unit interval in a charging amount-to-average matrix 430 in which the number of columns, 15, of the matrix 440 is less by 2 than the number of columns, 17, of the matrix 430.

The processor 120 may calculate an indicator of each battery cell in every charging cycle by applying a weight value to a change degree of the charging amount-to-average, and an example of the indicator is shown as a matrix 450.

Thereafter, the processor 120 may identify a maximum value among the indicators for each battery cell. For example, the processor 120 may derive a matrix 460 by identifying a maximum value among indicators for each row of the matrix 450. The processor 120 may diagnose abnormality of the battery cell by comparing the identified maximum value with the threshold value using a matrix 460.

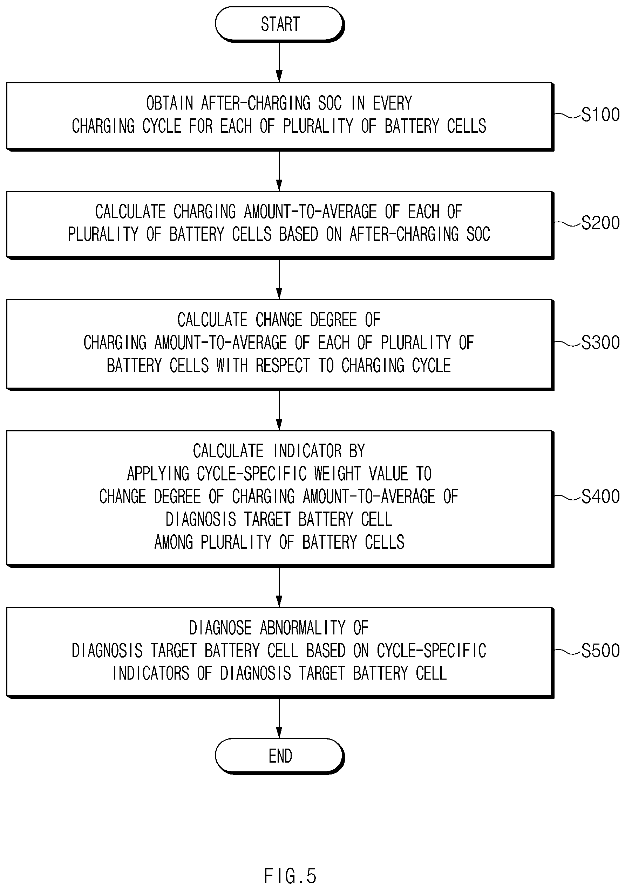

FIGS. 5 to 7 are flowcharts of a battery diagnosis method according to an embodiment disclosed herein.

Referring to FIG. 5, the battery diagnosis method may include operation S100 of obtaining after-charging SOC every charging cycle for each of a plurality of battery cells, operation S200 of calculating a charging amount-to-average of each of the plurality of battery cells based on the after-charging SOC, operation S300 of calculating a change degree of the charging amount-to-average with respect to a charging cycle of each of the plurality of battery cells, operation S400 of calculating an indicator by applying a cycle-specific weight value to a change degree of a charging amount-to-average of a diagnosis target battery cell among the plurality of battery cells, and operation S500 of diagnosing abnormality of the diagnosis target battery cell based on cycle-specific indicators of the diagnosis target battery cell.

In operation S100, the interface unit 110 may obtain after-charging SOC in every charging cycle for each of a plurality of battery cells. In an embodiment, the interface unit 110 may obtain SOC after a designated time from the end of each charging cycle, for each of the plurality of battery cells.

In operation S200, the one or more processors 120 may calculate a charging amount-to-average of each of the plurality of battery cells.

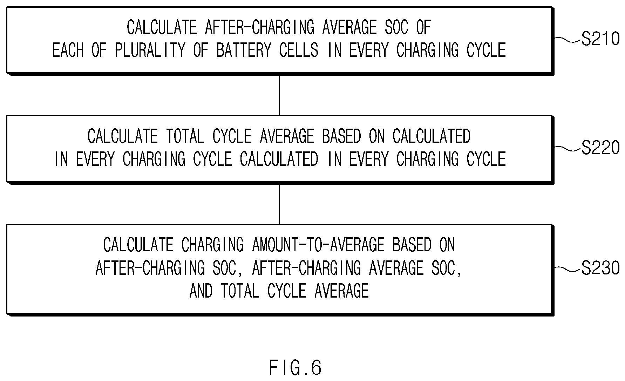

Referring to FIG. 6, a method, performed by the processor 120 according to an embodiment, of calculating the charging amount-to-average may include operation S210 of calculating after-charging average SOC of each of the plurality of battery cells in every charging cycle, operation S220 of calculating a total cycle average based on the after-charging average SOC calculated in every charging cycle, and operation S230 of calculating a charging amount-to-average based on the after-charging SOC, the after-charging average SOC, and the total cycle average.

In operation S210, the processor 120 may average after-charging SOC of the plurality of battery cells in a corresponding charging cycle in every charging cycle to calculate the after-charging average SOC.

In operation S220, the processor 120 may average again the after-charging average SOC calculated in every charging cycle to calculate the total cycle average.

In operation S230, the processor 120 may calculate a charging amount-to-average based on the after-charging SOC, the after-charging average SOC, and the total cycle average. In an embodiment, the processor 120 may calculate the charging amount-to-average based on Equation 1.

In operation S300, the processor 120 may calculate a change degree of the charging amount-to-average of each of the plurality of battery cells with respect to a charging cycle. In an embodiment, the processor 120 may calculate a difference between a charging amount-to-average in a first charging cycle among the plurality of charging cycles and a charging amount-to-average in a second charging cycle previous to the first charging cycle, as a change degree of a charging amount-to-average corresponding to the first charging cycle.

In operation S400, the processor 120 may calculate an indicator by applying a cycle-specific weight value to a change degree of a charging amount-to-average of a diagnosis target battery.

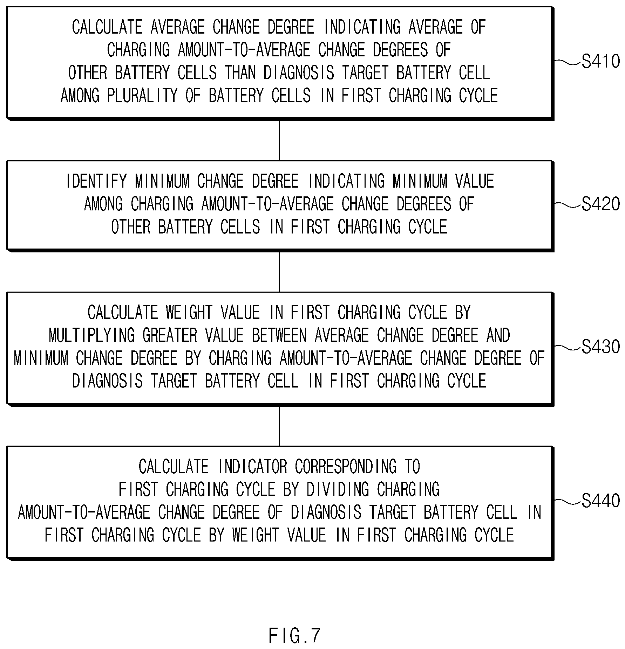

Referring to FIG. 7, a method, performed by the processor 120 according to an embodiment, of calculating the indicator may include operation S410 of calculating an average change degree indicating an average of charging amount-to-average change degrees of the other battery cells than a diagnosis target battery cell among the plurality of battery cells in a first charging cycle, operation S420 of identifying a minimum change degree indicating a minimum value among the charging amount-to-average change degrees of the other battery cells in the first charging cycle, operation S430 of calculating a weight value in the first charging cycle by multiplying the greater value between an average change degree and a minimum change degree by the charging amount-to-average change degree of the diagnosis target battery cell in the first charging cycle, and operation S440 of calculating an indicator corresponding to the first charging cycle by dividing the charging amount-to-average change degree of the diagnosis target battery cell in the first charging cycle by the weight value in the first charging cycle.

In operation S410, the processor 120 may average charging amount-to-average change degrees of the other battery cells than the diagnosis target battery cell in the first charging cycle to calculate an average change degree.

In operation S420, the processor 120 may identify a minimum change degree indicating a minimum value among the charging amount-to-average change degrees of the other battery cells than the diagnosis target battery cell.

In operation S430, the processor 120 may multiply the greater value between the average change degree and the minimum change degree by the charging amount-to-average change degree in the first charging cycle to calculate the weight value in the first charging cycle.

In operation S440, the processor 120 may divide the charging amount-to-average change degree of the diagnosis target battery cell in the first charging cycle by the weight value to calculate the indicator corresponding to the first charging cycle.

As such, the processor 120 may calculate an indicator of the diagnosis target battery cell for each cycle.

In operation S500, the processor 120 may diagnose abnormality of the diagnosis target battery cell based on cycle-specific indicators of the diagnosis target battery cell. In an embodiment, the processor 120 may compare a maximum value among the cycle-specific indicators of the diagnosis target battery cell with a threshold value to diagnose abnormality of the diagnosis target battery cell. For example, the processor 120 may diagnose that the diagnosis target battery cell is abnormal when the maximum value among the indicators of the diagnosis target battery cell exceeds the threshold value.

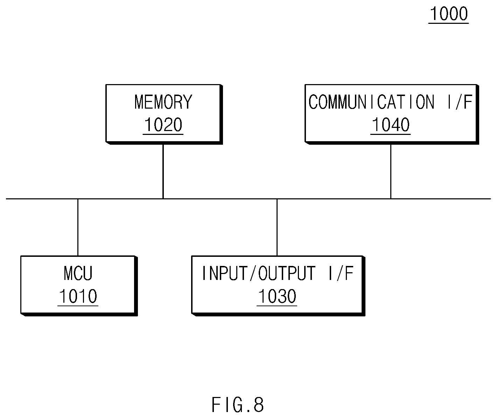

FIG. 8 is a block diagram showing a hardware configuration of a computing system for performing an operating method of a battery diagnosis apparatus, according to an embodiment disclosed herein.

Referring to FIG. 8, a computing system 1000 according to an embodiment disclosed herein may include a microcontroller unit (MCU) 1010, a memory 1020, an input/output interface (I/F) 1030, and a communication I/F 1040.

The memory 1010 may be a processor that executes various programs stored in the memory 1020, processes various information including time-series data of the battery through such programs, and causes functions of a processor included in the battery diagnosis apparatus shown in FIG. 1 to be performed.

The memory 1020 may store various programs for performing functions of the battery diagnosis apparatus. The memory 1020 may also store various information including battery data (after-charging SOC, etc.), a diagnosis prediction result, etc.

The memory 1020 may be provided in plural, depending on a need. The memory 1020 may be a volatile or nonvolatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., with the MCU 1010.

The communication I/F 1040, which is a component capable of transmitting and receiving various data to and from a server, may be various types of devices capable of supporting wired or wireless communication. For example, the battery diagnosis apparatus may transmit and receive various information including battery data, etc., from an external server separately provided through the communication I/F 1040.

As such, a computer program according to an embodiment disclosed herein may be recorded in the memory 1020 and processed by the MCU 1010, thus being implemented as a module that performs functions shown in FIG. 1.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

**Claims**

**1.** A battery diagnosis apparatus comprising:

an interface unit configured to obtain after-charging state of charge (SOC) in every charging cycle, for each of a plurality of battery cells; and
one or more processors configured to:

calculate a charging amount-to-average of each of the plurality of battery cells, based on the after-charging SOC;
calculate a change degree of the charging amount-to-average of each of the plurality of battery cells with respect to a charging cycle;
calculate an indicator by applying a cycle-specific weight value to a change degree of a charging amount-to-average of a diagnosis target battery cell among the plurality of battery cells; and
diagnose abnormality of the diagnosis target battery cell based on cycle-specific indicators of the diagnosis target battery cell.

2. The battery diagnosis apparatus of claim 1, wherein the interface unit is further configured to obtain SOC after a designated time from end of each charging cycle, for each of the plurality of battery cells.

3. The battery diagnosis apparatus of claim 1, wherein the processor is further configured to:

calculate after-charging average SOC of each of the plurality of battery cells in every charging cycle;
calculate a total cycle average based on the after-charging average SOC calculated in every charging cycle; and
calculate the charging amount-to-average based on the after-charging SOC, the after-charging average SOC, and the total cycle average.

4. The battery diagnosis apparatus of claim 1, wherein the processor is further configured to calculate a difference between a charging amount-to-average in a first charging cycle among the plurality of charging cycles and a charging amount-to-average in a second charging cycle previous to the first charging cycle, as the change degree of the charging amount-to-average corresponding to the first charging cycle.

5. The battery diagnosis apparatus of claim 1, wherein the processor is further configured to:

calculate an average change degree indicating an average of charging amount-to-average change degrees of the other battery cells than the diagnosis target battery cell among the plurality of battery cells in the first charging cycle;
identify a minimum change degree indicating a minimum value among the charging amount-to-average change degrees of the other battery cells in the first charging cycle; and
calculate a weight value in the first charging cycle by multiplying a greater value between the average change degree and the minimum change degree by a charging amount-to-average change degree of the diagnosis target battery cell in the first charging cycle.

6. The battery diagnosis apparatus of claim 5, wherein the processor is further configured to calculate an indicator corresponding to the first charging cycle by dividing the charging amount-to-average change degree of the diagnosis target battery cell in the first charging cycle by a weight value in the first charging cycle.

7. The battery diagnosis apparatus of claim 1, wherein the processor is further configured to diagnose abnormality of the diagnosis target battery cell by comparing a maximum value among cycle-specific indicators of the diagnosis target battery cell with a threshold value.

8. A battery diagnosis method comprising:

obtaining after-charging state of charge (SOC) in every charging cycle, for each of a plurality of battery cells;
calculating a charging amount-to-average of each of the plurality of battery cells, based on the after-charging SOC;
calculating a change degree of the charging amount-to-average of each of the plurality of battery cells with respect to a charging cycle;
calculating an indicator by applying a cycle-specific weight value to a change degree of a charging amount-to-average of a diagnosis target battery cell among the plurality of battery cells; and
diagnosing abnormality of the diagnosis target battery cell based on cycle-specific indicators of the diagnosis target battery cell.

9.  The battery diagnosis method of claim 8, wherein the obtaining of the after-charging SOC comprises obtaining SOC after a designated time from end of each charging cycle, for each of the plurality of battery cells.

10. The battery diagnosis method of claim 8, wherein the calculating of the charging amount-to-average of each of the plurality of battery cells comprises:

    calculating after-charging average SOC of each of the plurality of battery cells in every charging cycle;
    calculating a total cycle average based on the after-charging average SOC calculated in every charging cycle; and
    calculating the charging amount-to-average based on the after-charging SOC, the after-charging average SOC, and the total cycle average.

11. The battery diagnosis method of claim 8, wherein the calculating of the change degree of the charging amount-to-average comprises calculating a difference between a charging amount-to-average in a first charging cycle among the plurality of charging cycles and a charging amount-to-average in a second charging cycle previous to the first charging cycle, as the change degree of the charging amount-to-average corresponding to the first charging cycle.

12. The battery diagnosis method of claim 8, wherein the calculating of the indicator comprises:

    calculating an average change degree indicating an average of charging amount-to-average change degrees of the other battery cells than the diagnosis target battery cell among the plurality of battery cells in the first charging cycle;
    identifying a minimum change degree indicating a minimum value among the charging amount-to-average change degrees of the other battery cells in the first charging cycle;
    calculating a weight value in the first charging cycle by multiplying a greater value between the average change degree and the minimum change degree by a charging amount-to-average change degree of the diagnosis target battery cell in the first charging cycle; and
    calculating an indicator corresponding to the first charging cycle by dividing the charging amount-to-average change degree of the diagnosis target battery cell in the first charging cycle by a weight value in the first charging cycle.

13. The battery diagnosis method of claim 8, wherein the diagnosing of abnormality of the diagnosis target battery cell comprises diagnosing abnormality of the diagnosis target battery cell by comparing a maximum value among cycle-specific indicators of the diagnosis target battery cell with a threshold value.

100

| INTERFACE UNIT 110 | ONE OR MORE PROCESSORS 120 |
|---|---|

FIG.1

FIG.2

310

FIG.3A

FIG.3B

<u>330</u>

CHANGE OF CHARGING
AMOUNT-TO-AVERAGE

FIG.3C

340

INDICATOR

FIG.3D

350

MAXIMUM VALUE
AMONG INDICATORS

FIG.3E

[76.13, 76.01, 75.79, 75.87, ..., 75.34, 75.06, 74.69, 75.27]
[76.10, 75.99, 75.76, 75.78, ..., 75.23, 74.96, 74.63, 75.17]

410

[76.13, 76.01, 75.80, 75.82, ..., 75.26, 75.01, 74.61, 75.19]
[75.96, 75.84, 75.65, 75.67, ..., 75.19, 74.90, 74.51, 75.14]

420 → [76.10, 76.00, 75.80, 75.80, ..., 75.30, 75.00, 74.60, 75.20]

norm = 75.41

[75.44, 75.44, 75.43, 75.48, ..., 75.49, 75.49, 75.49, 75.48]
[75.42, 75.42, 75.40, 75.39, ..., 75.38, 75.38, 75.43, 75.38]

430

[75.44, 75.44, 75.43, 75.43, ..., 75.41, 75.43, 75.41, 75.41]
[75.44, 75.44, 75.29, 75.28, ..., 75.34, 75.32, 75.31, 75.35]
[75.27, 75.27, 75.27, ...

[0.01, 0.05, 0.07, 0.02, ..., 0.00, 0.01, 0.01, 0.00]
[0.02, 0.02, 0.01, 0.01, ..., 0.00, 0.00, 0.05, 0.00]

440

[0.00, 0.00, 0.01, 0.00, ..., 0.02, 0.00, 0.00, 0.02]
[0.02, 0.01, 0.01, 0.01, ..., 0.02, 0.01, 0.03, 0.03]

[0.01, 0.05, 0.07, 0.02, ..., 0.00, 0.01, 0.01, 0.00]
[0.02, 0.02, 0.01, 0.01, ..., 0.00, 0.00, 0.05, 0.00]

450

[0.00, 0.00, 0.01, 0.00, ..., 0.02, 0.00, 0.00, 0.02]
[0.02, 0.01, 0.01, 0.01, ..., 0.02, 0.01, 0.03, 0.03]

460
[0.51
 0.14
 0.09
 0.05
 0.04
 0.03
 0.03
 0.06]

FIG. 4

START

OBTAIN AFTER-CHARGING SOC IN EVERY
CHARGING CYCLE FOR EACH OF PLURALITY OF BATTERY CELLS ── S100

CALCULATE CHARGING AMOUNT-TO-AVERAGE OF EACH OF
PLURALITY OF BATTERY CELLS BASED ON AFTER-CHARGING SOC ── S200

CALCULATE CHANGE DEGREE OF
CHARGING AMOUNT-TO-AVERAGE OF EACH OF PLURALITY OF
BATTERY CELLS WITH RESPECT TO CHARGING CYCLE ── S300

CALCULATE INDICATOR BY
APPLYING CYCLE-SPECIFIC WEIGHT VALUE TO
CHANGE DEGREE OF CHARGING AMOUNT-TO-AVERAGE OF
DIAGNOSIS TARGET BATTERY CELL
AMONG PLURALITY OF BATTERY CELLS ── S400

DIAGNOSE ABNORMALITY OF
DIAGNOSIS TARGET BATTERY CELL BASED ON CYCLE-SPECIFIC
INDICATORS OF DIAGNOSIS TARGET BATTERY CELL ── S500

END

FIG.5

CALCULATE AFTER-CHARGING AVERAGE SOC OF
EACH OF PLURALITY OF BATTERY CELLS IN EVERY CHARGING CYCLE ⌐S210

CALCULATE TOTAL CYCLE AVERAGE BASED ON CALCULATED
IN EVERY CHARGING CYCLE CALCULATED IN EVERY CHARGING CYCLE ⌐S220

CALCULATE CHARGING AMOUNT-TO-AVERAGE BASED ON
AFTER-CHARGING SOC, AFTER-CHARGING AVERAGE SOC,
AND TOTAL CYCLE AVERAGE ⌐S230

FIG.6

```
┌─────────────────────────────────────────────────────────────┐
│         CALCULATE AVERAGE CHANGE DEGREE INDICATING AVERAGE OF │
│                CHARGING AMOUNT-TO-AVERAGE CHANGE DEGREES OF    │      ~S410
│         OTHER BATTERY CELLS THAN DIAGNOSIS TARGET BATTERY CELL │
│          AMONG PLURALITY OF BATTERY CELLS IN FIRST CHARGING CYCLE │
└─────────────────────────────────────────────────────────────┘
                              │
┌─────────────────────────────────────────────────────────────┐
│        IDENTIFY MINIMUM CHANGE DEGREE INDICATING MINIMUM VALUE │
│            AMONG CHARGING AMOUNT-TO-AVERAGE CHANGE DEGREES OF  │      ~S420
│                 OTHER BATTERY CELLS IN FIRST CHARGING CYCLE    │
└─────────────────────────────────────────────────────────────┘
                              │
┌─────────────────────────────────────────────────────────────┐
│             CALCULATE WEIGHT VALUE IN FIRST CHARGING CYCLE BY  │
│       MULTIPLYING GREATER VALUE BETWEEN AVERAGE CHANGE DEGREE AND │
│ MINIMUM CHANGE DEGREE BY CHARGING AMOUNT-TO-AVERAGE CHANGE DEGREE OF │  ~S430
│             DIAGNOSIS TARGET BATTERY CELL IN FIRST CHARGING CYCLE │
└─────────────────────────────────────────────────────────────┘
                              │
┌─────────────────────────────────────────────────────────────┐
│                 CALCULATE INDICATOR CORRESPONDING TO          │
│               FIRST CHARGING CYCLE BY DIVIDING CHARGING       │
│ AMOUNT-TO-AVERAGE CHANGE DEGREE OF DIAGNOSIS TARGET BATTERY CELL IN │  ~S440
│        FIRST CHARGING CYCLE BY WEIGHT VALUE IN FIRST CHARGING CYCLE │
└─────────────────────────────────────────────────────────────┘
```

FIG.7

1000

```
        MEMORY                COMMUNICATION I/F
         1020                      1040



────────────────┬───────────────────────┬────────────────


        ┌──────────┐         ┌──────────────────┐
           MCU                INPUT/OUTPUT I/F
           1010                     1030
```

FIG.8

## INTERNATIONAL SEARCH REPORT

| International application No. |
| --- |
| **PCT/KR2024/018214** |

**A. CLASSIFICATION OF SUBJECT MATTER**

**G01R 31/382**(2019.01)i; **G01R 31/392**(2019.01)i; **G01R 31/367**(2019.01)i; **G01R 19/165**(2006.01)i; **G01R 31/56**(2020.01)i; **H02J 7/00**(2006.01)i

According to International Patent Classification (IPC) or to both national classification and IPC

**B. FIELDS SEARCHED**

Minimum documentation searched (classification system followed by classification symbols)

G01R 31/382(2019.01); G01R 19/00(2006.01); G01R 31/387(2019.01); G01R 31/392(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 진단 장치(battery diagnostic apparatus), 배터리 셀(battery cell), 충전 사이클(charging cycle), SOC(state of charging), 평균(average)

**C. DOCUMENTS CONSIDERED TO BE RELEVANT**

| Category* | Citation of document, with indication, where appropriate, of the relevant passages | Relevant to claim No. |
| --- | --- | --- |
| A | KR 10-2021-0048810 A (LG CHEM, LTD.) 04 May 2021 (2021-05-04) See paragraphs [0039]-[0044], claim 1 and figure 1. | 1-13 |
| A | KR 10-2021-0066609 A (LG CHEM, LTD.) 07 June 2021 (2021-06-07) See paragraphs [0034]-[0038], claim 1 and figure 2. | 1-13 |
| A | KR 10-2556993 B1 (SAMSUNG SDI CO., LTD.) 17 July 2023 (2023-07-17) See paragraphs [0034]-[0076] and figures 1-6. | 1-13 |
| A | KR 10-2023-0168900 A (LG ENERGY SOLUTION, LTD.) 15 December 2023 (2023-12-15) See claims 1-14 and figures 1-10. | 1-13 |
| A | KR 10-2021-0064931 A (LG ENERGY SOLUTION, LTD.) 03 June 2021 (2021-06-03) See claims 1-10 and figures 1-8. | 1-13 |

☐ Further documents are listed in the continuation of Box C.   ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **25 February 2025** | **25 February 2025** |

| Name and mailing address of the ISA/KR | Authorized officer |
| --- | --- |
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/018214**

| Patent document cited in search report | | | Publication date (day/month/year) | Patent family member(s) | | | Publication date (day/month/year) |
|---|---|---|---|---|---|---|---|
| KR | 10-2021-0048810 | A | 04 May 2021 | CN | 114207454 | A | 18 March 2022 |
| | | | | CN | 114207454 | B | 20 June 2023 |
| | | | | EP | 3998489 | A1 | 18 May 2022 |
| | | | | EP | 3998489 | A4 | 10 August 2022 |
| | | | | JP | 2022-534442 | A | 29 July 2022 |
| | | | | JP | 7205032 | B2 | 17 January 2023 |
| | | | | US | 2022-0317197 | A1 | 06 October 2022 |
| | | | | WO | 2021-080219 | A1 | 29 April 2021 |
| KR | 10-2021-0066609 | A | 07 June 2021 | CN | 113994224 | A | 28 January 2022 |
| | | | | EP | 3961234 | A1 | 02 March 2022 |
| | | | | EP | 3961234 | A4 | 10 August 2022 |
| | | | | EP | 3961234 | B1 | 20 November 2024 |
| | | | | JP | 2022-535766 | A | 10 August 2022 |
| | | | | JP | 7403775 | B2 | 25 December 2023 |
| | | | | US | 11815558 | B2 | 14 November 2023 |
| | | | | US | 2022-0317196 | A1 | 06 October 2022 |
| | | | | WO | 2021-107323 | A1 | 03 June 2021 |
| KR | 10-2556993 | B1 | 17 July 2023 | KR | 10-2022-0040190 | A | 30 March 2022 |
| KR | 10-2023-0168900 | A | 15 December 2023 | | None | | |
| KR | 10-2021-0064931 | A | 03 June 2021 | CN | 113767293 | A | 07 December 2021 |
| | | | | CN | 113767293 | B | 10 November 2023 |
| | | | | EP | 3988953 | A1 | 27 April 2022 |
| | | | | EP | 3988953 | A4 | 31 August 2022 |
| | | | | EP | 3988953 | B1 | 18 September 2024 |
| | | | | ES | 2991484 | T3 | 03 December 2024 |
| | | | | HU | E068554 | T2 | 28 January 2025 |
| | | | | JP | 2022-532544 | A | 15 July 2022 |
| | | | | JP | 2023-086771 | A | 22 June 2023 |
| | | | | JP | 7259085 | B2 | 17 April 2023 |
| | | | | US | 12032028 | B2 | 09 July 2024 |
| | | | | US | 2022-0317192 | A1 | 06 October 2022 |
| | | | | WO | 2021-107655 | A1 | 03 June 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240054760